Europäisches Patentamt

European Patent Office

Office européen des brevets

(11) Veröffentlichungsnummer: **0 257 327**
**A2**

## EUROPÄISCHE PATENTANMELDUNG

Anmeldenummer: 87110949.2

(51) Int. Cl.⁴: **H01L 21/00**

Anmeldetag: 28.07.87

Priorität: 25.08.86 DE 3628850

Veröffentlichungstag der Anmeldung:
02.03.88 Patentblatt 88/09

Benannte Vertragsstaaten:
CH DE FR GB IT LI SE

(71) Anmelder: Siemens Aktiengesellschaft Berlin
und München
Wittelsbacherplatz 2
D-8000 München 2(DE)

(72) Erfinder: Haller, Heinrich, Dipl.-Ing.
Saarwerderstrasse 17
D-4000 Düsseldorf 11(DE)
Erfinder: Heimüller, Hans-Jost
Am Schafgarten 9
D-6724 Dudenhofen(DE)

(54) Vorrichtung zum Greifen von elektrischen Bauelementen.

(57) Die Bauelemente sind von Greiffingern (4, 10) eines Robotergreifers an ihren Anschlußelementen gehalten. Zusätzlich dazu sind Klemmfedern (8, 9) vorgesehen, die den Bauelementkörper (2) nachgiebig einklemmen, wodurch die Greifsicherheit erhöht wird.

# FIG 1

EP 0 257 327 A2

## Vorrichtung zum Greifen von elektrischen Bauelementen

Die Erfindung bezieht sich auf eine Vorrichtung zur Durchführung eines Verfahrens zum automatisierten Einsetzen von in die gleiche Richtung weisenden Anschlußelementen eines elektrischen Bauelementes in Öffnungen eines Trägerteiles mittels eines Greifers, der das Bauelement an seinen Anschlußelementen in der Nähe von deren freien Enden ergreift, gemäß der deutschen Offenlegungsschrift 35 13 679, wonach die Anschlußelemente vor dem Greifvorgang leicht auseinandergespreizt angeordnet werden und wonach der Greifer die Anschlußelemente von außen umgreift und deren freie Enden auf ein gewünschtes Maß zusammendrückt.

Durch das Spreizen und Zusammendrücken der Anschlußelemente entsteht zu den Greiffingern eine Federspannung, durch die das Bauelement eingeklemmt gehalten werden kann. Bei schwereren Bauelementen, z.B. Relais oder Blockkondensatoren besteht die Gefahr, daß durch die beim Verfahren des Greifers auftretenden Beschleunigungskräfte die Anschlußelemente über ihre Vorspannung hinaus belastet werden, verringern, so daß die erforderliche Lagegenauigkeit des Bauelementes gegenüber dem Greifer nicht gewährleistet ist, was zur Fehlbestückung und Zerstörung des Bauelementes führen kann.

Der Erfindung liegt die Aufgabe zugrunde, die Greifsicherheit zu erhöhen.

Diese Aufgabe wird durch die Erfindung gemäß Anspruch 1 Transporteinrichtung für die beschnittenen Bauelemente zu einer Spreizstation entfällt. Die Bauelemente können vielmehr direkt von der kombinierten Beschneide-und Spreizstaion mittels des Greifers entnommen werden. Durch die Zusammenfassung der Funktionen in einem Werkzeug wird auch die Baubreite der Einrichtung entsprechend gering. Es ist üblich, die einseitig an den abzuschneidenden Enden der Anschlußelemente gegurteten Bauelemente über eine Stachelwalze laufen zu lassen, in deren vorderster Position das Bauelement beschnitten und dem Greifer übergeben wird. Da die kombinierte Station nicht breiter wird als eine einfache Beschneidestation wird die Baubreite der gesamten Zuführeinrichtung nicht vergrößert. Dies ist besonders wichtig, da eine Vielzahl von derartigen Zuführeinrichtungen dem Greifbereich eines Bestückungsroboters zugeordnet wird. Dabei ist es besonders wichtig, die Baubreite gering zu halten, um eine möglichst große Anzahl unterschiedlicher Bauelemente bereithalten zu können. Die Vorrichtung kann durch Einsetzen von Schnittstempeln mit unterschiedlich breiten Spreizdornen verschiedenen Bauelementtypen mit unterschiedlich beabstandeten Anschlußelementen angepaßt werden. Aus diesem Grunde wird der Schnittstempel leicht austauschbar angeordnet. Bei Gelegenheit des Auswechselns können auch die Schnittflächen des Schnittstempels nachgeschliffen werden. Der Spreizdorn kann auch einen Teil der Schnittkräfte aufnehmen.

Vorteilhafte Weiterbildungen der Erfindung sind in den Ansprüchen 2 bis 6 gekennzeichnet.

Durch die Weiterbildung nach Anspruch 2 kann der Schnittstempel zwischen der Schnittplatte und der Stützplatte beim Schneidvorgang geführt werden, wobei sich eine großflächige Abstützung an der Stützplatte ergibt.

Die Weiterbildung nach Anspruch 3 ermöglicht das Ausweichen der abgeschnittenen Anschlußelemente in der Schnitt Greifformen für die Anschlußelemente aufweisen. Diese Kante kann z.B mit der Außenseite der Blattfeder im Greifzustand fluchten. Dadurch können auch in dieser Richtung die Bauelemente einander eng benachbart aneinandergereiht werden.

Die Weiterbildung nach Anspruch 6 ermöglicht einen geringen Federweg bei ausreichend hoher Haltekraft. Dies ist insbesondere für die als Federdraht gebildeten Klemmfedern von Vorteil, deren Trägheitsmoment geringer ist.

Im folgenden wird die Erfindung anhand von in der Zeichnung dargestellten Ausführungsbeispielen näher erläutert.

Fig. 1 zeigt eine Seitenansicht von gegeneinander verstellbaren Greiffingern eines Greifers für einen Handhabungsroboter mit einem elektrischen Bauelement,

Fig. 2 eine perspektivische Darstellung des Greiffingers nach Fig. 1,

Fig. 3 eine perspektische Ansicht eines anderen Greiffingers des Greifers.

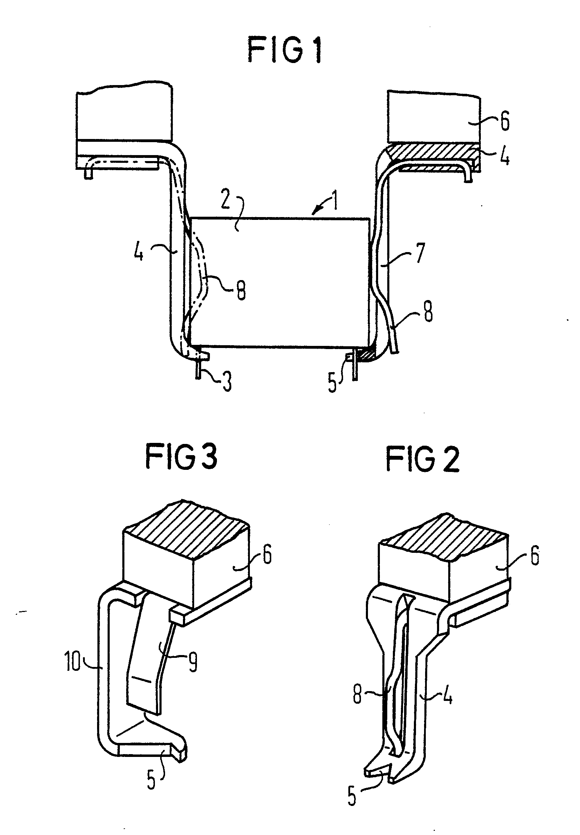

Nach den Fig. 1 und 2 besteht ein elektrisches Bauelement 1 aus einem Bauelementkörper 2 und Anschlußelementen 3. Das Bauelement 1 ist zwischen zwei Greiffingern 4 eines nicht näher dargestellten Greifers eines Handhabungsroboters gehalten. Die Greiffinger 4 sind mit Greifformen 5 versehen, mit denen sie an den Anschlußelementen 3 von außen her angreifen. Diese sind zuvor auseinandergespreizt und durch die Greifformen 5 definiert so weit zusammengedrückt worden, daß ihre freien Enden einen genauen Abstand voneinander aufweisen. Die Greiffinger 4 erstrecken sich von der den Anschlußelementen 3 abgewandten Seite her entlang den Stirnseiten des Bauelementkörpers 2 zu den Greifformen 5. Sie sind aus Flachmaterial gebogen und mit einem Schenkel an Fingerhaltern 6 befestigt.

In einen mittleren Längsschlitz 7 des Greiffingers 4 ist eine gebogene Drahtfeder 8 als Klemmfeder eingesetzt. Sie ist mit einem Ende an dem am Fingerhalter 6 befestigten Schenkel des Greiffingers 4 gehalten. Die Drahtfeder 8 ragt im Bereich der ihr zugewandten Stirnseite des Bauelementekörpers 2 aus dem Längsschlitz 7 heraus und liegt unter Spannung an dem Bauelementkörper 2 an. Die strichpunktiert dargestellte Drahtfeder 8 ist in der ungespannten Lage vor dem Greifen des Bauelementes 1 dargestellt. Sie liegt mit ihrem freien Ende von außen her unter Vorspannung am dem Greiffinger 4 an.

Nach Fig. 3 ist die Klemmfeder als einseitig eingespannte freiragende Blattfeder 9 ausgebildet. Ein anderer Greiffinger 10 ist ebenfalls am Fingerhalter 6 befestigt. Er besteht ebenfalls aus Flachmaterial und ist U-förmig um die Blattfeder 9 herumgebogen. Dabei erstrecken sich die Biegekanten in der Greifrichtung. Die Greifform 5 am freien Ende des Greiffingers 10 kann ein elektrisches Bauelement an einem der Anschlußelemente erfassen. Die Blattfeder 9 kann sich mit ihrem freien Ende an eine z.B. gewölbte Mantelfläche des Bauelementkörpers anlegen und zusammen mit dem diametral gegenüberliegenden Greiffinger nachgiebig einklemmen.

## Ansprüche

1. Vorrichtung zur Durchführung eines Verfahrens zum automatisierten Einsetzen von in die gleiche Richtung weisenden Anschlußelementen (3) eines elektrischen Bauelementes (1) in Öffnungen eines Trägerteiles mittels eines Greifers, der das Bauelement (1) an seinen Anschlußelementen (3) in der Nähe von deren freien Enden ergreift, wobei die Anschlußelemente (3) vor dem Greifvorgang leicht auseinandergespreizt angeordnet werden und der Greifer die Anschlußelemente (3) von außen umgreift und deren freie Enden auf ein gewünschtes Maß zusammendrückt,
**dadurch gekennzeichnet,**
daß der Greifer mit Greiffingern (4, 10) und Klemmfedern (z. B. 8, 9) zum Einklemmen des Bauelementkörpers (2) versehen ist.

2. Vorrichtung nach Anspruch 1,
**dadurch gekennzeichnet,**
daß die Klemmfedern als Biegefedern ausgebildet sind, die eine zum Bauelementkörper (2) hin konvexe Wölbung aufweisen, an der das gegriffene Bauelement (1) anliegt.

3. Vorrichtung nach Anspruch 2,
**dadurch gekennzeichnet,**
daß die Klemmfedern als Drahtfedern (8) ausgebildet und in einem Längsschlitz (7) des Greiffingers (4) versenkbar geführt sind.

4. Vorrichtung nach Anspruch 2,
**dadurch gekennzeichnet,**
daß die Klemmfedern als Blattfedern (9) ausgebildet sind.

5. Vorrichtung nach Anspruch 4,
**dadurch gekennzeichnet,**
daß die Greiffinger (10) aus Flachmaterial gebogen sind, dessen Biegekanten sich in der Greifrichtung erstrecken und daß ein unterer Schenkel der Greiffinger (10) Greifformen (5) für die Anschlußelemente der Bauelemente aufweist.

6. Vorrichtung nach Anspruch 3, 4 oder 5,
**dadurch gekennzeichnet,**
daß die Klemmfedern (8) unter Vorspannung an den Greiffingern (7) gehalten sind.

# FIG 1

# FIG 3

# FIG 2